# EUROPEAN PATENT SPECIFICATION

(11) **EP 1 020 766 B1**
(45) Date of publication and mention of the grant of the patent: **02.05.2007**
(21) Application number: 00300181.5
(22) Date of filing: 12.01.2000
(51) Int. Cl.: G03F 7/027

(54) **Photosensitive resin composition for flexographic printing plates**
Lichtempfindliche Harzzusammensetzung für Flexodruckplatten
Composition photosensible à base de résine pour des plaques d'impressions flexographiques

(30) Priority: 14.01.1999 US 231421
(43) Date of publication of application: 19.07.2000
(73) Proprietor: MACDERMID INCORPORATED, Waterbury, Connecticut 06702 (US)
(72) Inventor: Leach, Douglas Dr., Hockessin, Delaware (US); Sungail, Rosemarie Palmer, Chadds Ford, PA 19317 (US)
(74) Representative: Jenkins, Peter David

(56) References cited:
- EP-A- 0 927 911
- US-A- 4 245 030
- US-A- 4 716 094
- US-A- 5 688 633

## Description

The present invention relates to a photosensitive resin composition which can be used to prepare relief printing plates which are free of surface tack, and which are resistant to degradation by ultraviolet radiation, and to printing plates made therefrom.

Photopolymer printing plates for flexographic printing can be manufactured from either liquid photosensitive resin compositions, or photosensitive solid sheet compositions. Liquid photosensitive resin compositions typically comprise a prepolymer having ethylenically unsaturated groups, such as an acrylate or methacrylate ester at each end of the molecule, one or more ethylenically unsaturated compounds (eg. monomers or oligomers), and a photopolymerization initiator. The flexographic printing plate is produced by exposing the liquid photosensitive resin to actinic radiation, first from one side to form the background, or floor, of the printing plate, and then imagewise through a photographic negative, or other mask, and then removing the uncured resin through a developing process, a post-exposure process, and a drying process to produce a relief image

Unless specific means are taken to reduce the surface tackiness of said photopolymer printing plates, the surface of the printing relief of said printing plates can be quite tacky. Excessive tackiness of the printing surface can result in the rapid accumulation of dried ink and paper fibers on the surface of the plate, and would also fill in reverse areas of the plate as well as deposit on the edges of the printing characters. All of these occurrences result in what is know as dirty printing, which requires stoppage of the press and cleaning the printing plates. In addition, excessive tackiness of the plates can actually cause the corrugated board, or paper web being printed on to adhere to the surface of the plate, interrupting the printing operation.

Several methods are well known in the art to reduce the surface tack of said liquid photopolymer printing plates. U.S. Patent, 4,716,094 discloses that tack reducing additives, such as fatty acids, fatty acid amides, fatty alcohols, and thioesters can be incorporated into the liquid photosensitive resin to reduce the surface tack of the printing plate. Surface tack is reduced by taking advantage of the low solubility of the tack reducing additive in the cured photopolymer resin, and its ability to migrate to the surface of the plate and provide a slippery surface. However, these additives can be washed away, or dissolved in printing inks or cleaners used during the printing process, reducing the tack-free nature of the plate. Other than post-curing the photopolymer printing plate after development, no additional chemical reactions are required or induced by these additives.

U.S. Patent 4,202,696 discloses that the surface tack of cured photosensitive resins can be reduced by impregnating the surface of the object with a specific organic carbonyl compound, such as benzophenone, and then irradiating the composition with actinic radiation having a wavelength of from 200 to 300 nm. Typically, the surface is impregnated with said organic carbonyl compound by dipping it in a solution of said carbonyl compound in an appropriate volatile solvent, such as iso-propanol, or ethanol. Typical organic carbonyl compounds included benzophenone, substituted benzophenones, and substituted anthraquinones. Unfortunately, such suitable solvents are often extremely flammable, and cannot be readily used without very substantial ventilation systems, and modifications of all electrical equipment present to make it explosion proof.

U.S. Patent 4,806,506 discloses a process for detackifying a relief printing plate by applying an aprotic organic solvent to the surface of the plate after developing the plate and drying, and prior to exposing the surface of the plate to radiation with wavelength in the range of 200 to 300 nm.

European Patent applications EP 674,229 and EP 691,357 describe the use of a photosensitive resin containing both a first photoinitiator system which is operative to cure the photosensitive resin upon exposure to radiation having wavelengths of at least 300 nm, and a second photoinitiator system comprising a carbonyl compound, such as benzophenone in conjunction with an amine-modified polyurethane prepolymer, which is operative to detackify the surface of the printing plate upon exposure to radiation having wavelengths in the range of 200 to 300 nm. The use of volatile solvents can be avoided in this case by incorporating said organic carbonyl compound into the liquid photosensitive resin itself, eliminating the need to impregnate it into the surface of the cured article.

It is also known that said organic carbonyl compounds, such as benzophenone, are triplet photosensitizers which greatly accelerate the photodegradation of polyurethanes at wavelengths of 350 nm and higher. Thus, while printing plates either dipped in solutions of benzophenone, or manufactured from resins containing benzophenone, and then subjected to irradiation from germicidal lamps, may be completely without tack when initially prepared, the polymer is subject to rapid degradation. Indeed, when stored under sunlight, or fluorescent or metal-halide type lighting, which emits a small fraction of its output at wavelengths below 400 nm, any such printing plates will rapidly be degraded in their mechanical properties, such as tensile strength, elongation and resistance to chipping or other physical damage.

The concept of reducing surface tack, or of obtaining a tack-free surface, as used in the instant invention, refers to more than the state in which the amount of tack of the cured photopolymer printing plate is decreased or avoided. In photopolymer printing plates, a plate which has been developed or washed out to remove uncured resin, post-exposed under water, and dried, may be considered initially to have little or no tack on the surface. However, it has been found that after contacting the surface of the plate with inks, ink cleaners or alcohol, the surface can consequently become very tacky to the touch. Therefore, the concept of preparing a tack-free surface according to the instant invention involves a permanent state of reduced or eliminated tack.

Up to the present time, no attempt has been able to overcome the accelerated degradation of photopolymer printing plates which occurs in the presence of benzophenone with UV light stabilizers or absorbers which do not prohibit the curing of the photosensitive resin itself. It has now surprisingly been found that permanently tack-free relief printing plates which are resistant to degradation by UV light can be prepared using a photosensitive resin comprising an aromatic, or polyunsaturated carboxylic acid or ester and subjecting said printing plates to radiation having wavelengths in the range of from 200 to 300 nm.

An aim of the present invention is to provide a photosensitive resin composition for producing a relief printing plate which is permanently free of tack, and which does not suffer degradation upon long term exposure to low levels of light of wavelengths less than about 400 nm. A further of this invention is to provide a process for producing said permanently tack-free printing plate.

According to a first aspect of the present invention there is provided a photopolymer composition comprising: (a) polyurethane prepolymer; (b) ethylenically unsaturated monomer; (c) photoinitiator; and (d) a tack-reducing additive selected from the group consisting of 4-hydroxybenzoic acid, 4-methoxybenzoic acid, 4-alkoxybenzoic acids, methyl 4-hydroxybenzoate, methyl 4-methoxybenzoate, 2-thiophenecarboxylic acid, cinnamic acid, 2,4-hexadienoic acid, and mixtures thereof.

According to a second aspect of the present Invention there is provided a printing plate comprising a layer of the photoreaction product of a photopolymer composition of the first aspect of the present invention upon a substrate.

According to a third aspect of the present invention there is provided a process for fabricating a printing plate, said process comprises: (a) providing a layer of the photopolymer of the first aspect of the present invention composition upon a substrate and subjecting the photopolymer composition to actinic radiation in an imagewise fashion, (b) thereby creating polymerised photopolymer composition and unpolymerised photopolymer composition; developing away any unpolymerised photopolymer composition; and (c) subjecting the polymerised photopolymer composition to actinic radiation of a wavelength or from 200nm to 300nm.

Embodiments of the present invention provide a photosensitive resin composition comprising (i) a polyurethane oligomer, (ii) a monomer having at least one ethylenically unsaturated group, (iii) a photopolymerization initiator, and (iv) a tack-reducing additive. Flexographic printing plates produced with such resins can be made completely and permanently tack-free by postexposure using radiation of wavelength from 200 nm to 300 nm, and are also resistant to degradation upon prolonged exposure to low levels of actinic radiation at wavelengths of 300 nm and above.

An embodiment of the present invention provides photopolymerisable resin compositions according to present claim 1 which can be used to prepare relief plates comprising:
(A) from 50% to 98% by weight of a polyurethane prepolymer,
(B) from 1.0% to 50% of an ethylenically unsaturated monomer, or mixture of said monomers,
(C) from 0.2% to 5.0% of a photoinitiator, and
(D) from 0.5% to 5.0% of a tack reducing additive

The prepolymer used as component (A) in the embodiment is a polyurethane prepolymer having one or more terminal ethylenically unsaturated groups, such as methacrylate or acrylate esters. The urethane prepolymer may be formed by the reaction of polyetherdiol, or a blend of polyether diols, a molecule having at least two isocyanate groups, preferably a diisocyanate, and a molecule having at least one hydroxyl group and at least one (meth)acrylate group, also known as a hydroxy-functionalized (meth)acrylate. Suitable polyether diols include Acclaim 3201, Acclaim 3205, Acclaim 4220 and Acclaim 2220, available from Arco Chemical of Newtowne Square, PA. Other polyether diols would be suitable as well.

The diisocyanate used to prepare the polyurethane prepolymer of the invention is preferably an aromatic diisocyanate, although an aliphatic diisocyanate can be used just as well. Typical aromatic diisocyanates include methylene diphenyldiisocyanate (a.k.a. diphenylmethane-4,4'-diisocyanate), meta- and para-xylylene diisocyanate, toluene-2,4-diisocyanate, toluene-2,6-diisocyanate or mixtures of the latter two isomers (a.k.a. 2,4- and 2,6- toluene diisocyanate), naphthalene-1,5-diisocyanate, phenyl benzyl ether 4,4'-diisocyanate and the like.

Aliphatic and/or cycloaliphatic diisocyanates may be used as the diisocyanate component. Suitable aliphatic diisocyanates include, for example, those having 2 to 12 carbon atoms in the aliphatic radical, for example, hexamethylene diisocyanate, 2,2,4-trimethylhexamethylene diisocyanate and the like. Suitable cycloaliphatic diisocyanates include, for example, 1,4-diisocyanate-cyclohexane, dicyclohexylmethane-4,4'-diisocyanate (a.k.a. bis-cyclohexylmethylene diisocyanate), isophorone diisocyanate and the like.

It is preferred to react the diisocyanate in equivalent excess with the diol, in order that isocyanate terminated polyurethane oligomers are produced. The molar ratio of diol component to diisocyanate component is preferably between 1.0:1.08 and 1.0:1.5, and more preferably between 1.0:1.12 and 1.0:1.3. The number average molecular weights of the polyurethane oligomers are preferably between 6,000 and 40,000, and more preferably between 8,000 and 30,000, and most preferably between 12,000 and 20,000

Preferably, the reaction between the diol and the diisocyanate is achieved by contacting the reactants in the presence of a catalyst, preferably dibutyltin dilaurate or other such alkyltin catalyst, at an effective concentration, preferably from 50 to 100 ppm. The reaction temperature should be 60°C, at which temperature the reaction time will be approximately 4 hours.

After reacting the polyether diol with an excess of diisocyanate, to give an isocyanate-terminated polyurethane oligomer, the oligomer is reacted with a hydroxyacrylate or hydroxymethacrylate to introduce ethylenic unsaturation into the oligomer and provide a urethane prepolymer. Suitable hydroxyacrylates or hydroxy methacrylates include, without limitation, 2-hydroxypropyl (meth)acrylate, polypropylene glycol monomethacrylate, polypropylene glycol monoacrylate, or acrylated caprolactone oligomers. Of these, polypropylene glycol monomethacrylate and acrylated caprolactone oligomer are preferred for producing soft photopolymers necessary for printing on corrugated board or other cellulosic substrate having an irregular surface.

The monomer(s) used as component (B) of the photosensitive resin composition of the invention is a monomer having at least one acrylate group, also known as a reactive monomer, or simply a monomer. The reactive monomer of the instant invention may be any commonly available molecule having one or more photopolymerizable functional groups. A preferred reactive monomer is a mono- or poly- acrylate or methacrylate compound, including esters thereof. The designation (meth)acrylate will be used herein to simultaneously refer to one or both of methacrylates and acrylates.

The use of a compound having two or more ethylenically unsaturated groups in the molecule increases the hardness of the printing plate. Therefore, the amount of such compounds to be used should be controlled so that a printing plate having the desired hardness is obtained. For this reason, it is preferred that the reactive monomer be a mixture of a mono (meth)acrylate ester and a poly(meth)acrylate ester.

Exemplary reactive monomers are the esters of acrylic acid and/or methacrylic acid with monohydric or polyhydric alcohols, and include, for example and without limitation, butyl (meth)acrylate, 2-ethylhexyl (meth)acrylate, isodecyl (meth)acrylate, lauryl (meth)acrylate, phenoethoxy (meth)acrylate, ethylene glycol monoethylether mono (meth)acrylate, diethylene glycol monoethylether mono(meth)acrylate, triethyleneglycol monoethyl ether mono(meth)acrylate, ethylene glycol di(meth)acrylate, 2-hydroxyethyl (meth)acrylate, hexane-1,6-diol di(meth)acrylate, 1,1,1-trimethylolpropane tri(meth)acrylate, di, tri, and tetraethylene glycol di(meth)acrylate, tripropylene glycol di(meth)acrylate, pentaerythritol tetra(meth)acrylate, propoxylated trimethylolpropane mono- di- and tri-(meth)acrylate, ethoxylated trimethylolpropane tri(meth)acrylate, and oligomeric polybutadienes with (meth)acrylic acid, i.e., oligomeric polybutadienes possessing activated, photopolymerizable olefinic double bonds.

Preferred monomers are lauryl methacrylate, polypropyleneglycol monomethacrylate, diethyleneglycol monoethylether monoacrylate, trimethylolpropane trimethacrylate and tetraethyleneglycol dimethacrylate.

The proportion of reactive monomer in the photosensitive resin formulation of the invention is dictated at least in part by the desired viscosity of the resulting liquid photosensitive resin. The greater the amount of monomer incorporated into the photosensitive resin, the lower is the resultant viscosity of the resin, for a given molecular weight of polyurethane prepolymer. The viscosity of the photosensitive resin is preferably between 10,000 mPa.s (100,00 cps) and 100,000 mPa.s (100,000 cps) at use temperature, and more preferably between 20,000 mPa.s (20,000 cps) and 50,000 mPa.s (50,000 cps), Most preferably, it is from 25,000 mPa.s (25,000 cps) to 40,000 mPa.s (40,000 cps). The amount of unsaturated reactive monomer required for a given molecular weight polyurethane prepolymer to achieve a given viscosity for the photosensitive resin can be readily determined by one skilled in the art without undue experimentation.

Typically, the reactive monomer is present in from 10 to 35 weight percent of the photopolymerizable mixture, and more preferably in from 15 to 30 weight percent of the mixture.

The photo initiator(s) used as component (C) of the photosensitive resin composition of the invention can be any of the photoinitiators customarily used in relief printing plates. Representative photoinitiators include acylphosphineoxide, benzoin methyl ether, benzoin isopropyl ether, benzoin n-butyl ether, benzoin isobutyl ether, benzophenone, 2,2-dimethoxy-2-phenylacetophenone, i.e., Irgacure®651 (Ciba-Geigy), benzil 1-methyl 1-ethyl ketal, 2-chlorothioxanthone, dibenzosuberone, 2,2-diethoxy-2-phenylacetophenone, 2,2-diethoxyacetophenone, 2-dimethoxybenzoyldiphenylphosphine oxide, 4,4'-bis(dimethylamino)benzophenone, ethyl 2,4,6-trimethylbenzoylphenyl phosphinate, 1-hydroxycyclohexyl phenyl ketone, 4'-morpholinodeoxybenzoin and 2,4,6-trimethylbenzoyldiphenylphosphine oxide.

The amount of the photopolymerization initiator can be any effective concentration which will allow the formation of a floor layer to the flexographic printing plate via a back exposure of a reasonable length of time and the formation of the relief image with the required image resolution. This time is related to the type of image being formed, as well as the thickness of the desired flexographic printing plate. The effective amount of photopolymerization initiator is dependent on the type of initiator chosen.

A concentration range of 0.1-10 wt% photoinitiator is suggested. When the amount of photoinitiator is less than 0.1%, the ultraviolet setting density is lowered and the physical properties of the photopolymer plate are extremely lowered. When the photoinitiator amount exceeds 5 wt%, no beneficial effect is observed for any property, and the cost of the formulation becomes commercially undesirable. Higher concentrations of photoinitiator can also make the resulting printing plate more succeptible to degradation in the presence of low levels of actinic radiation.

For 2,2-dimethoxy-2-phenylacetophenone, the photoinitiator(s) is used in the photopolymerizable mixtures in an amount of from 0.1% to 5%, preferably 0.2% to 1.5%, and more preferably from 0.25% to 0.75%.

The tack-reducing additive used as component (D) of the photosensitive resin composition of the invention absorbs actinic radiation at a wavelength of from 200 nm to 300 nm, preferably from 245 nm to 265 nm, more preferably at 254 nm, and has substantially no absorbance of actinic radiation at wavelengths of 300 nm or higher, more preferably 330 nm or higher. The tack-reducing additive is selected from the group consisting of 4-hydroxybenzoic acid, 4-methoxybenzoic acid, 4-alkoxybenzoic acids, methyl 4-hydroxybenzoate, methyl 4-methoxybenzoate, 2-thiophenecarboxylic acid, cinnamic acid, 2,4-hexadieneoic acid and mixtures thereof. Preferred tack-reducing additives include 4-hydroxybenzoic acid and 4-methoxybenzoic acid. The tack reducing additive may be present in from 0.5% to 5% by weight. More preferably, it is present in from 0.75% to 3% by weight. Most preferably, it is present in from 1% to 2% by weight.

In addition to the above described components A, B, C and D the photopolymerizable resins of the invention may also contain other additional additives, such as thermal antioxidants, ultraviolet light absorbers, hindered amine light stabilizers, dyes, pigments or plasticizers. Exemplary antioxidants include, for example, sterically hindered monophenols, such as 2,6-di-tert-butyl-p-cresol (BHT), alkylated thiobisphenols and alkylidenebisphenols, such as 2,2-methylenebis-(4-methyl-6-tert-butylphenol) or 2,2-bis (1-hydroxy-4-methyl-6-tert-butylphenyl) sulfide. BHT is a preferred antioxidant.

The preparation of the printing plate from the photosensitive resin of the instant invention can be accomplished by any customary method used with other photosensitive resins. That is, the photosensitive resin may be provided as a layer of uniform thickness between a substrate backing sheet and a cover sheet facing a photographic negative and subjecting the layer to a back exposure and image exposure with actinic radiation, followed by development of the plate.

The substrate backing sheet, also known as the support, can be any flexible material which is conventionally used with photosensitive elements used to prepare flexographic printing plates. Examples of suitable substrate materials include polymeric films such as those formed by addition polymers and linear condensation polymers, transparent foams and fabrics. A preferred substrate is a polyester film; particularly preferred is polyethylene terephthalate. The substrate typically has a thickness from 2 to 10 mils (0.0051 to 0.025 cm), with a preferred thickness of 4 to 7 mils (0.010 to 0.018 cm).

Examples of suitable sources of actinic radiation are sunlight and commercial UV fluorescent tubes, medium pressure, high pressure and low pressure mercury lamps, superactinic fluorescent tubes, pulsed xenon lamps, lamps doped with metal iodides and carbon arc lamps. Preferably, the photopolymer plates used in the present invention are cured with ultraviolet rays having a wavelength of 150-500 nm, especially 300-400 nm, which are generated by a low-pressure mercury lamp, high-pressure mercury lamp, carbon arc lamp, ultraviolet fluorescent lamp, chemical lamp, xenon lamp, or zirconium lamp.

There are several types of apparatus in practical use for the development of photopolymer plates. One forms the relief by spraying the washout solution under pressure to the plate. Another forms the relief by blowing off the unexposed part by means of compressed air. Yet another forms the relief by rubbing a brush against the plate fixed to a flat surface or cylinder, thereby dissolving the unexposed part in the solution. It is preferred that the photopolymer plate, after curing by exposure to one of the above-mentioned light source, be developed with a developer, also known as a washout solution, which removes the unexposed non-image part. This process forms a relief image on the photopolymer plate. The unexposed part which has been removed by the washout solution remains in the form of emulsion or suspension in the washout solution in the washout bath.

It is preferred to use an aqueous developer. The developer is most desirably water (tap water) having a pH 5.0-9.0 which may optionally contain an alkaline compound and a surfactant. The addition of a surfactant is desirable for the photopolymer to readily disperse into water and to remain dispersed in water. Preferred surfactants are sodium alkylnaphthalenesulfonate and sodium alkylbenzenesulfonate. Other examples of the surfactant include anionic surfactants containing a carboxylate, sulfate-ester, sulfonate, or phosphate-ester; nonionic surfactants such as polyethylene glycol derivative, polyhydric alcohol derivative, and sorbitan derivative; cationic surfactants containing a primary, secondary or tertiary amine salt, or a quaternary ammonium salt; and amphoteric surfactants containing an amino acid hydrophilic group or a betaine hydrophilic group. Preferred alkaline compounds are sodium hexametaphosphate, sodium tripolyphosphate, sodium hydroxide and sodium carbonate. The washout solution should be used at 25°-50°C, preferably 30°-40°C. The concentration of the surfactant in water is not limited, but is generally in the range of 0.5% to 4%. While the plate is most often developed by spray washing with the aqueous developer solution, other techniques, including those mentioned above, may be used as well. Optionally, a defoamer, such as a silicone antifoam, may be added to the aqueous developer solution.

After the development step, curing of the partially polymerized photosensitive resin in the background and sides of the plate is completed by exposure to actinic radiation under a solution of an oxygen absorbing compound, such as sodium bisulfite, to prevent oxygen inhibition of the polymerization. The surface of the plate is then rendered permanently tack-free by exposure to actinic radiation of wavelength from 200 nm to 300 nm. A preferred wavelength of actinic radiation is that at 254 nm produced by germicidal lamps, such as Voltarc GRFX 5058 lamps manufactured by Voltarc Technologies. The detackification is preferably conducted at a temperature of from 37.8°C (100°F) to 60°C (140°F). More preferably, the detackification is conducted at a temperature of from 51.7°C (125°F) to 60°C (140°F).

### General Procedures

The surface tack of a printing plate is measured in terms of the value of the stress required to separate a steel foot which has been forced onto the surface of a sample plate using an Omega force meter model DFG-2 obtained from Omega Engineering Inc. The particulars of the method for measuring the surface tack as mentioned above are described below. A printing plate is attached to a level support in such a manner that the relief face of the plate is directed upward. A steel foot of 6.35 mm (0.25") in radius attached to a digital force gauge is brought into contact with the plain portion of the relief face of the plate. A load of 500 g is applied to the steel foot as measured with Omega force meter and allowed to stand for 10 seconds: Then, the foot is lifted upward at a constant elevation speed of 12.7 mm/min (0.5"/min) until the plate is separated from the foot. The value of the stress just before the separation of the foot from the plate is measured using an Omega force meter. Printing plates prepared according to the instant invention will have a tack value as determined by the above procedure of 50 g or less, preferably 25 g or less.

Each of the photopolymerizable compositions of the following examples was formed into a photopolymer printing plate according to the following procedure. Using a Merigraph® type 3048 exposure unit, a 6.35 mm (0.250") thick layer of the photosensitive resin composition was formed as a layer between an adhesive coated polyester backing sheet and a cover sheet of polypropylene film, which separated the photo resin from a photographic negative, as shown in the illustration. The photopolymer was subjected to a backside exposure of 2:30, followed by an imaging exposure through the negative for 6:00. After the exposure, the cover sheet was removed and the uncured resin was removed by spray washing with an aqueous solution containing 2% by weight Merigraph® washout detergent W6410L and 2% by weight sodium triphosphate at 35-40°C for ten minutes to obtain a relief plate. Then the plate was immersed in an aqueous solution of sodium bisulfite and subjected to postexposure by actinic radiation having a minimum intensity of 8 mW/cm² to completely cure the relief portion of the plate. The plate was then dried for from 30 to 45 minutes at 40°C. The plate may then be subjected to a dry post-exposure step under germicidal lamps for 10 to 20 minutes under a row of Voltarc GRFX 5058 germicidal lamps placed approximately 15 cm from the surface of the photopolymer printing plate. The surface tack of each plate was measured as described above. Photosensitive resin compositions were cured for tensile strength and elongation Measurements by casting a 1.016 mm (0.040") thick layer of the photosensitive resin composition between a 0.1016 mm (0.004") uncoated polyester sheet and a polypropylene film. The photopolymer was subjected to a backside exposure of 30 seconds followed by a frontside exposure of 400 seconds. The polyester and polypropylene films were peeled away and the samples were die-cut for tensile testing according to ASTM method D-412.

Samples were tested for resistance to UV degradation by exposing cured samples to radiation from a Cooper Lighting model M-59 metal-halide type 400 watt lamp. The UV light intensity was measured with an IL 1400A radiometer from International Lighting Inc. The light was installed at a distance above the samples to produce a measured UV intensity of 100 µW/cm². Imaged 6.35 mm (0.250") plates, or 1.016 mm (0.040") thick solid sheets were irradiated for 120 hours continuously and then examined to determine either the resistance of the characters in the imaged plate to damage, or the tensile strength and elongation of sheets.

### Example 1

1349 g (0.429 moles) of Acclaim 3205, 90 (0.515 moles) grams of TDI and 0.10 grams of dibutyltin dilaurate (DBTDL) catalyst were charged into a 2 liter resin kettle equipped with a nitrogen purge, an air stirrer and a thermocouple. After an initial exothermic reaction, the reaction mixture was kept at 60°C for 2 hours until the isocyanate concentration had reached 0.50% by weight, as determined by titration with di-n-butylamine. Then a mixture of 160.0 grams (0.421 moles) of polypropyleneglycol monomethacrylate (MW 380 g/mole), 1.6 g of BHT and 0.06 g of DBTDL was then added to the reaction mixture, and the contents were maintained at 60°C for 2 additional hours until titration indicated no remaining isocyanate.

To 70.0 grams of the resulting urethane prepolymer were added 14.5 grams of polypropyleneglycol monomethacrylate, 7.2 grams of lauryl methacrylate, 0.9 grams of trimethylolpropane trimethacrylate, 3.0 grams of tetraethyleneglycol dimethacrylate, 1.8 grams of N,N-diethylaminoethyl methacrylate, 0.5 grams of Irgacure 651, 0.1 grams of BHT and 2.0 grams of 4-hydroxybenzoic acid. The resulting mixture was stirred for 2 hours to obtain a photosensitive resin composition. The resin was made into a photopolymer printing plate, or 1.016 mm (0.040") thick sheet for measurement of tensile properties. The tensile strength and elongation of cured samples was 9177 kPa (1331 psi) and 330% respectively. After UV aging for 120 hours, the tensile strength and elongation were 7053 kPa (1023 psi) and 270%. The surface tack of a photopolymer printing plate made from the photosensitive resin was measured before and after exposure to germicidal lamps for 15 minutes is shown in Table 1.

The photopolymerizable resin above was formed into a photopolymer printing plate according to the following procedure. Using a Merigraph® type 3048 exposure unit, a 6.35 mm (0.250") thick layer of the photosensitive resin composition was formed as a layer between an adhesive coated polyester backing sheet and a cover sheet of polypropylene film, which separated the photo resin from a photographic negative. The photopolymer was subjected to a back-side exposure of 2:00, followed by an imaging exposure through the negative for 5:30. After the exposure, the cover sheet was removed and the uncured resin was removed by spray washing with an aqueous solution containing 2% by weight Merigraph® washout detergent W6410L and 2% by weight sodium triphosphate at 35-40°C for ten minutes to obtain a relief plate. Then the plate was immersed in an aqueous solution of sodium bisulfite and subjected to postexposure by actinic radiation having a minimum intensity of 9 mW/cm² to completely cure the relief portion of the plate. The plate was then dried for 30 minutes at 50°C. The plate was then subjected to a dry post-exposure step under germicidal lights for 15 minutes. The thus prepared printing plates were used to print 33,000 sheets of corrugated board. Ink transfer, coverage and color density were excellent, and any paper dust or fibers which became deposited on the plate readily released after several additional sheets were produced. It was not necessary to stop the press to clean the plates at all during the operation.

### Example 2

A photosensitive resin was prepared according to the procedure of example 1, except that 1.0 grams of 4-methoxybenzoic acid was used in place of 4-hydroxybenzoic acid. The tensile strength and elongation of cured samples was 8549 kPa (1240 psi) and 315% respectively. After UV aging for 120 hours, the tensile strength and elongation were 7412 kPa (1075 psi) and 285%. The surface tack of a photopolymer printing plate made from the photosensitive resin was measured before and after exposure to germicidal lamps for 15 minutes is shown in Table 1.

### Example 3

A photosensitive resin was prepared according to the procedure of example 1, except that 1.7 g of 2-thiophenecarboxylic acid was used in place of 4-hydroxybenzoic acid. The tensile strength and elongation of cured samples was 7584 kPa (1100 psi) and 340% respectively. After UV aging for 120 hours, the tensile strength and elongation were 5516 kPa (800 psi) and 280%. The surface tack of a photopolymer printing plate made from the photosensitive resin was measured before and after exposure to germicidal lamps for 20 minutes is shown in Table 1.

### Example 4

A photosensitive resin was prepared according to the procedure of example 1, except that 1.5 g of methyl 4-hydroxybenzoate was used in place of 4-hydroxybenzoic acid. The tensile strength and elongation of cured samples was 8446 kPa (1225 psi) and 300% respectively. After UV aging for 120 hours, the tensile strength and elongation were 7998 kPa (1160 psi) and 280%. The surface tack of a photopolymer printing plate made from the photosensitive resin was measured before and after exposure to germicidal lamps for 15 minutes is shown in Table 1.

### Example 5

A photosensitive resin was prepared according to the procedure of example 1, except that 0.7 g of 2,4-hexadienoic acid was used in place of 4-hydroxybenzoic acid. The tensile strength and elongation of cured samples was 6205 kPa (900 psi) and 315% respectively. After UV aging for 120 hours, the tensile strength and elongation were 4826 kPa (700 psi) and 275%. The surface tack of a photopolymer printing plate made from the photosensitive resin was measured before and after exposure to germicidal lamps for 20 minutes is shown in Table 1.

### Example 6

A photosensitive resin was prepared by blending 70.0 grams of the polyurethane prepolymer of example 1 with 14.5 grams of polypropyleneglycol monomethacrylate, 7.2 grams of lauryl methacrylate, 0.9 grams of trimethylolpropane trimethacrylate, 3.0 grams of tetraethyleneglycol dimethacrylate, 0.5 of grams Irgacure 651, 0.1 grams of BHT and 2.0 grams of 4-hydroxybenzoic acid for 2 hours. The resin was made into a photopolymer printing plate, or 1.016 mm (0.040") thick sheet for measurement of tensile properties. The tensile strength and elongation of cured samples was 9177 kPa (1331 psi) and 330% respectively. After UV aging for 120 hours, the tensile strength and elongation were 7053 kPa (1023 psi) and 270%. The surface tack of a photopolymer printing plate made from the photosensitive resin was measured before and after exposure to germicidal lamps for 15 minutes is shown in Table 1

A printing plate was prepared using the photosensitive resin above using the procedure of example 1. This printing plate was used to print over 15,000 sheets of corrugated board. During this test the press did not have to be stopped to clean the plates. There was no dried ink or paper fiber buildup on the side of the characters on the printing plate at the conclusion of the test.

### Example 7

A photosensitive resin was prepared according to the procedure of example 1, except that 1.5 grams of 4-hydroxybenzoic acid was used. The tensile strength and elongation of cured samples was 8412 kPa (1220 psi) and 320% respectively. After UV aging for 120 hours, the tensile strength and elongation were 7308 kPa (1060 psi) and 275%. The surface tack of a photopolymer printing plate made from the photosensitive resin was measured before and after exposure to germicidal lamps for 20 minutes is shown in Table 1.

### Comparative Example 1.

A photosensitive resin was prepared by blending for 2 hours 70.0 grams of the polyurethane prepolymer of example 1, 14.5 grams of polypropyleneglycol monomethacrylate, 7.2 grams of lauryl methacrylate, 0.9 grams of trimethylolpropane trimethacrylate, 3.0 grams of tetraethyleneglycol dimethacrylate, 1.8 grams of N,N-diethylaminoethyl methacrylate, 0.5 grams of Irgacure 651, 0.1 grams of BHT and 0.7 grams of benzophenone. The tensile strength and elongation of cured samples was 7446 kPa (1080 psi) and 300% respectively. After UV aging for 120 hours, the tensile strength and elongation were not measurable. After as short a time as 24 hours aging, the tensile strength and elongation had degraded to 2758 kPa (400 psi) and 150%. The surface tack of a photopolymer printing plate made from the photosensitive resin was measured before and after exposure to germicidal lamps for 7.5 minutes is shown in Table 1.

### Comparative Example 2

A photosensitive resin was prepared by blending for 2 hours 70.0 grams of the polyurethane prepolymer of example 1, 14.5 grams of polypropyleneglycol monomethacrylate, 7.2 grams of lauryl methacrylate, 0.9 grams of trimethylolpropane trimethacrylate, 3.0 grams of tetraethyleneglycol dimethacrylate, 1.8 grams of N,N-diethylaminoethyl methacrylate, 0.5 grams of Irgacure 651, 0.1 grams of BHT and 2.0 grams of myristic acid. The tensile strength and elongation of cured samples was 8274 kPa (1200 psi) and 330% respectively. After UV aging for 120 hours, the tensile strength and elongation were 6757 kPa (980 psi) and 290%. The surface tack of a photopolymer printing plate made from the photosensitive resin was measured before and after exposure to germicidal lamps for 15 minutes is shown in Table 1.

Printing plates were prepared with this photosensitive resin according to the method of example 1 and used to print 25,000 sheets of corrugated board. The printing press had to be stopped after approximately every 3000 to 4000 sheets to remove dried ink and paper fibers which had built up on the printing plate and not released.

**Table 1: Photopolymer plate surface tack**

| Example | surface tack before irradiation at 254 nm | surface tack after irradiation at 254 nm | germicidal post-exposure time |
|---|---|---|---|
| 1 | 304 2 | | 15 |
| 2 | 275 | 0 | 15 |
| 3 | 150 | 10 | 20 |
| 4 | 257 | 0 | 15 |
| 5 | 365 | 24 | 20 |
| 6 | 320 | 2 | 15 |
| 7 | 233 | 1 | 20 |
| Comparative 1 | 330 | 18 | 7.5 |
| Comparative 2 | 240 | 225 | 15 |

| | | | |
|---|---|---|---|
| Note: Surface tack was measured after exposing the plate surface to water based ink and cleaning with a water based ink cleaner. | | | |

## Claims

1. A photopolymer composition comprising:
(a) polyurethane prepolymer;
(b) ethylenically unsaturated monomer;
(c) photoinitiator; and
(d) a tack-reducing additive selected from the group consisting of 4-hydroxybenzoic acid, 4-methoxybenzoic acid, 4-alkoxybenzoic acids, methyl 4-bydroxybenzoate, methyl 4-methoxybenzoate, 2-thiophenecarboxylic acid, cinnamic acid, 2,4-hexadienoic acid, and mixtures thereof.

2. A composition according to claim 1 wherein the tack-reducing additive is selected from the group consisting of 4-hydroxybenzoic acid, 4-methoxybenzoic acid and mixtures thereof.

3. A composition according to claim 1 wherein the tack-reducing additive is present in the photopolymer composition at a concentration of from 0.75% by weight to 3% by weight.

4. A composition according to claim 1 wherein the tack-reducing additive absorbs actinic radiation of a wavelength of from 200nm to 330nm but has substantially no absorbance of actinic radiation of a wavelength above 330 nm.

5. A printing plate comprising a layer of the photoreaction product of the photopolymer composition of claim 1 upon a substrate.

6. A printing plate according to claim 5 wherein the tack-reducing additive is selected from the group consisting of 4-hydroxybenzoic acid, 4-methoxybenzoic acid and mixtures thereof.

7. A printing plate according to claim 5 wherein the tack-reducing additive is present in the photopolymer composition at a concentration of from 0.75% by weight to 3% by weight.

8. A printing plate according to claim 5 wherein the tack-reducing additive absorbs actinic radiation of a wavelength of from 200nm to 330nm but has substantially no absorbance of actinic radiation of a wavelength above 330nm.

9. A process for fabricating a printing plate, said process comprises:
(a) providing a layer of the photopolymer composition of claim 1 upon a substrate and subjecting the photopolymer composition to actinic radiation in an imagewise fashion;
(b) thereby creating polymerised photopolymer composition and unpolymerised photopolymer composition; developing away any unpolymerised photopolymer composition; and
(c) subjecting the polymerised photopolymer composition to actinic radiation of a wavelength of from 200nm to 300nm.

10. A process according to claim 9 wherein the tack-reducing additive is selected from the group consisting of 4-hydroxybenzoic acid, 4-methoxybenzoic acid and mixtures thereof.

11. A process according to claim 9 wherein the tack-reducing additive is present in the photopolymer composition at a concentration of from 0.75% by weight to 3% by weight.

12. A process according to claim 9 wherein the tack-reducing additive absorbs actinic radiation of a wavelength of from 200nm to 330non but has substantially no absorbance of actinic radiation of a wavelength above 330nm.

## Patentansprüche

1. Photopolymer-Zusammensetzung, umfassend:
(a) Polyurethan-Vorpolymer;
(b) ethylenisch ungesättigtes Monomer;
(c) Photoinitiator; und
(d) einen klebrigkeitsverringernden Zusatz, der ausgewählt ist aus der Gruppe bestehend aus 4-Hydroxybenzoesäure, 4-Methoxybenzoesäure, 4-Alkoxybenzoesäure, Methyl-4-hydroxybenzoat, Methyl-4-methoxybenzoat, 2-Thiophencarbonsäure, Zimtsäure, 2,4-Hexadiensäure und deren Mischungen.

2. Zusammensetzung nach Anspruch 1, bei der der klebrigkeitsverringernde Zusatz ausgewählt ist aus der Gruppe bestehend aus 4-Hydroxybenzoesäure, 4-Methoxybenzoesäure und deren Mischungen.

3. Zusammensetzung nach Anspruch 1, bei der der klebrigkeitsverringernde Zusatz in der Photopolymer-Zusammensetzung in einer Konzentration von 0,75 Gew.-% bis 3 Gew.-% vorliegt.

4. Zusammensetzung nach Anspruch 1, bei der der klebrigkeitsverringernde Zusatz aktinische Strahlung einer Wellenlänge von 200 nm bis 330 nm absorbiert, aber im Wesentlichen keine Extinktion aktinischer Strahlung einer Wellenlänge über 330 nm aufweist.

5. Druckplatte, umfassend eine Schicht des Photoreaktionsprodukts der Photopolymer-Zusammensetzung nach Anspruch 1 auf einem Substrat.

6. Druckplatte nach Anspruch 5, bei der der klebrigkeitsverringernde Zusatz ausgewählt ist aus der Gruppe bestehend aus 4-Hydroxybenzoesäure, 4-Methoxybenzoesäure und deren Mischungen.

7. Druckplatte nach Anspruch 5, bei der der klebrigkeitsverringernde Zusatz in der Photopolymer-Zusammensetzung in einer Konzentration von 0,75 Gew.-% bis 3 Gew.-% vorliegt.

8. Druckplatte nach Anspruch 5, bei der der klebrigkeitsverringernde Zusatz aktinische Strahlung einer Wellenlänge von 200 nm bis 330 nm absorbiert, aber im Wesentlichen keine Extinktion aktinischer Strahlung einer Wellenlänge über 330 nm aufweist.

9. Verfahren zur Herstellung einer Druckplatte, wobei das Verfahren umfasst:
(a) Bereitstellen einer Schicht der Photopolymer-Zusammensetzung nach Anspruch 1 auf einem Substrat und bildweises Einwirkenlassen aktinischer Strahlung auf die Photopolymer-Zusammensetzung;
(b) **dadurch** Schaffen von polymerisierter Photopolymer-Zusammensetzung und nicht-polymerisierter Photopolymer-Zusammensetzung; Wegentwickeln jeglicher nicht-polymerisierter Photopolymer-Zusammensetzung; und
(c) Einwirkenlassen von aktinischer Strahlung einer Wellenlänge von 200 nm bis 300 nm auf die polymerisierte Photopolymer-Zusammensetzung.

10. Verfahren nach Anspruch 9, in dem der klebrigsverringernde Zusatz ausgewählt ist aus der Gruppe bestehend aus 4-Hydroxybenzoesäure, 4-Methoxybenzoesäure und deren Mischungen.

11. Verfahren nach Anspruch 9, bei dem der klebrigkeitsverringernde Zusatz in der Photopolymer-Zusammensetzung in einer Konzentration von 0,75 Gew.-% bis 3 Gew.-% vorliegt.

12. Verfahren nach Anspruch 9, bei dem der klebrigkeitsverringernde Zusatz aktinische Strahlung einer Wellenlänge von 200 nm bis 330 nm absorbiert, aber im Wesentlichen keine Extinktion aktinischer Strahlung einer Wellenlänge über 300 nm aufweist.

## Revendications

1. Composition de photopolymère comprenant :
(a) un prépolymère polyuréthane ;
(b) un monomère ayant une insaturation du type éthylène ;
(c) un photo-initiateur ; et
(d) un additif de réduction de collage sélectionné dans le groupe comprenant l'acide 4-hydroxybenzoïque, l'acide 4-méthoxybenzoïque, les acides 4-alkoxybenzoïques, le 4-hydroxybenzoate de méthyle, le 4-méthoxybenzoate de méthyle, l'acide 2-thiophène carboxylique, l'acide cinnamique, l'acide 2,4-hexadiénoïque et leurs mélanges.

2. Composition selon la revendication 1, dans laquelle l'additif de réduction de collage est choisi dans le groupe comprenant l'acide 4-hydroxybenzoïque, l'acide 4-méthoxybenzoïque et leurs mélanges.

3. Composition selon la revendication 1, dans laquelle l'additif de réduction de collage est présent dans la composition de photopolymère à une concentration de 0,75 à 3 % en poids.

4. Composition selon la revendication 1, dans laquelle l'additif de réduction de collage absorbe les rayonnements actiniques à une longueur d'onde de 200 à 330 nm mais n'a sensiblement pas d'absorption pour les rayonnements actiniques de longueur d'onde supérieure à 330 nm.

5. Plaque d'impression comprenant une couche de produits de photoréaction ayant la composition de photopolymère selon la revendication 1 sur un substrat.

6. Plaque d'impression selon la revendication 5, dans laquelle l'additif de réduction de collage est choisi dans le groupe comprenant l'acide 4-hydroxybenzoïque, l'acide 4-méthoxybenzoïque et leurs mélanges.

7. Plaque d'impression selon la revendication 5, dans laquelle l'additif de réduction de collage est présent dans la composition de photopolymère à une concentration de 0,75 à 3 % en poids.

8. Plaque d'impression selon la revendication 5, dans laquelle l'additif de réduction de collage absorbe les rayonnements actiniques à une longueur d'onde de 200 à 330 nm mais n'a sensiblement pas d'absorption pour les rayonnements actiniques de longueur d'onde supérieure à 330 nm.

9. Procédé de fabrication d'une plaque d'impression, ce procédé comprenant :
(a) prévoir une couche de la composition de photopolymère selon la revendication 1 sur un substrat et soumettre la composition de photopolymère à un rayonnement actinique en forme d'image ;
(b) créer ainsi une composition de photopolymère polymérisée et une composition de photopolymère non polymérisée, et éliminer par développement la composition photopolymère non polymérisée ; et
(c) soumettre la composition de photopolymère polymérisée à un rayonnement actinique dans la plage de longueur d'onde de 200 à 300 nm.

10. Procédé selon la revendication 9, dans lequel l'additif de réduction de collage est choisi dans le groupe comprenant l'acide 4-hydroxybenzoïque, l'acide 4-méthoxybenzoïque et leurs mélanges.

11. Procédé selon la revendication 9, dans lequel l'additif de réduction de collage est présent dans la composition de photopolymère à une concentration de 0,75 à 3 % en poids.

12. Procédé selon la revendication 9, dans lequel l'additif de réduction de collage absorbe les rayonnements actiniques à une longueur d'onde de 200 à 330 nm mais n'a sensiblement pas d'absorption pour les rayonnements actiniques de longueur d'onde supérieure à 330 nm.
